# FASCICULE DE BREVET EUROPEEN

(11) **EP 3 028 222 B1**
(45) Date de publication et mention de la délivrance du brevet: **28.04.2021**
(21) Numéro de dépôt: 14759023.6
(22) Date de dépôt: 30.07.2014
(51) Int. Cl.: G06K 19/077

(54) **ENTITÉ ÉLECTRONIQUE À COUPLAGE INTÉGRÉ ENTRE UN MICROCIRCUIT ET UNE ANTENNE ET PROCÉDÉ DE FABRICATION**
ELEKTRONISCHE ENTITÄT MIT ZWISCHEN EINER MIKROSCHALTUNG UND EINER ANTENNE INTEGRIERTER KUPPLUNG UND VERFAHREN ZUR HERSTELLUNG
ELECTRONIC ENTITY WITH COUPLING INTEGRATED BETWEEN A MICROCIRCUIT AND AN ANTENNA AND METHOD OF FABRICATION

(30) Priorité: 31.07.2013 FR 1357589
(43) Date de publication de la demande: 08.06.2016
(73) Titulaire: IDEMIA France, 92400 Courbevoie (FR)
(72) Inventeur: LAUNAY, François, F-92700 Colombes (FR)
(74) Mandataire: Santarelli
(86) Numéro de dépôt international: PCT/FR2014/051983
(87) Numéro de publication internationale: WO 2015/015121

(56) Documents cités:
- EP-A1- 2 525 304
- US-A1- 2012 074 233
- US-B1- 6 378 774

## Description

L'invention concerne une entité électronique à couplage intégré entre un microcircuit et une antenne, notamment une entité électronique ayant une interface duale, c'est-à-dire une entité comportant d'une part un module de communication par contact et d'autre part un corps dans lequel le module est incorporé et qui est muni d'une antenne de communication sans contact. Une telle entité peut être une carte à microcircuit telle que définie par la norme ISO - 7816.

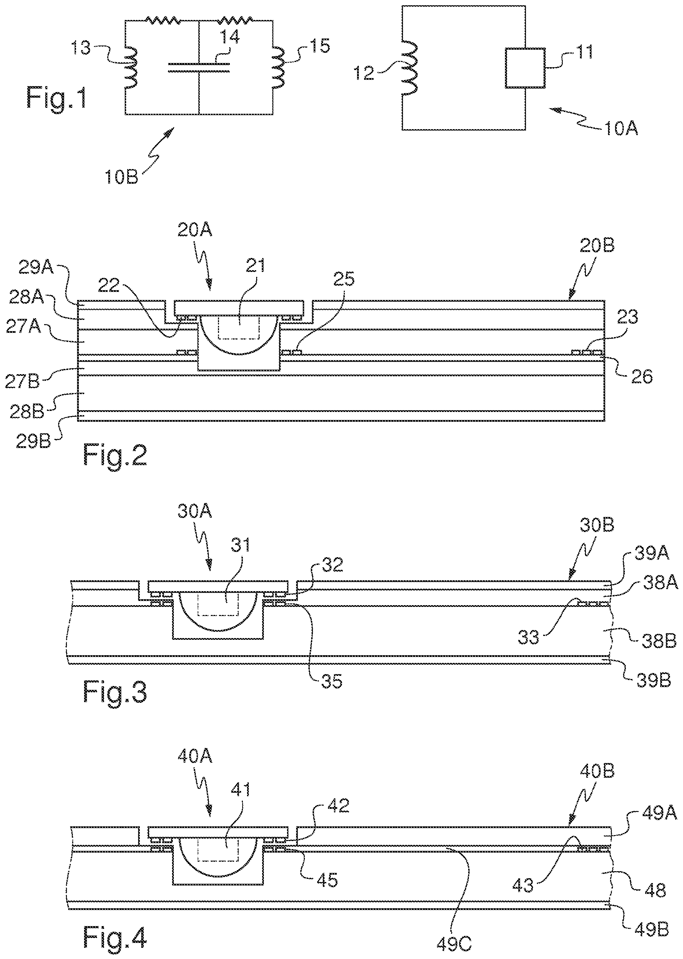

De manière classique, une entité ayant une telle interface duale comporte deux bobinages (ou antennes) de couplage électromagnétique respectivement situés dans le plan de l'antenne et sur le module ; sur la figure 1, le module 10A est schématisé par le composant à droite, comportant un microcircuit 11 et un bobinage de couplage 12 (il y a en outre des contacts de connexion à un lecteur extérieur mais ceux-ci ne sont pas représentés, par souci de simplicité), tandis que le corps 10B est schématisé à gauche avec une antenne 13 connectée par une capacité 14 à un second bobinage de couplage 15. La qualité de la connexion entre le microcircuit et l'antenne dépend de la qualité du couplage entre les bobinages 12 et 15.

Une telle configuration est par exemple décrite dans le document US - 6,378,774 (ou son équivalent européen, EP - 1 031 939) concernant une carte à microcircuit. Le module y est, de manière classique, formé d'un film support dont une première face, dite face externe, comporte des plages de contact et une seconde face, dite face interne, à laquelle est fixée un microcircuit connecté aux plages de contact au travers du film de support. Le corps de carte y comporte une feuille de support sur laquelle sont formées d'une part l'antenne et d'autre part l'autre bobinage de couplage, pouvant être aussi bien à l'extérieur de l'antenne qu'à l'intérieur de celle-ci ; le corps de carte est formé par moulage par injection, de part et d'autre de la feuille de support, d'une matière en pratique similaire à celle de cette feuille ; dans le corps ainsi formé est ensuite formée une cavité dans laquelle le module est fixé ; le bobinage de couplage formé sur la feuille de support y est localisé de manière à être à proximité du bobinage du module lorsque ce module est fixé dans cette cavité. Selon une forme de réalisation, l'emplacement de la feuille de support est situé en dessous de la cavité et le bobinage de couplage porté par le module est formé sur cette seconde face ; l'écart entre les deux bobinages de couplage est alors de l'ordre de grandeur de la profondeur de la cavité. Dans une autre forme de réalisation, le bobinage porté par le module est enroulé autour du microcircuit et la cavité traverse au moins en partie la feuille de support de l'antenne ; le bobinage de couplage formé dans cette feuille de support est alors situé approximativement à la même profondeur que le bobinage de couplage du module, mais latéralement à distance de celui-ci.

Selon encore une autre configuration (voir le document EP-2 525 304), le bobinage de couplage situé dans la plan de l'antenne peut être formé par une portion de cette antenne qui est conformée localement de manière appropriée.

De même, le document US - 2012/074233 divulgue une carte à microcircuit comportant, d'une part, un module portant un microcircuit et une petite antenne et, d'autre part, un corps muni d'une cavité recevant ce module et comportant une grande antenne dont les spires longent la périphérie de ce corps de carte, dans laquelle un couplage électromagnétique entre la petite antenne du module et la grande antenne est réalisé sans bobinage associé à cette grande antenne.

On connaît en pratique deux manières de former un corps de carte (et plus généralement de corps d'entité électronique) ; soit on procède par surmoulage (en pratique par injection) sur une feuille de support, comme cela est proposé dans les documents US - 6,378,774 ou EP - 1 031 939 précités), soit on procède par lamination d'une pluralité de couches (voir le schéma de la figure 2), à savoir deux couches (optionnelles) de compensation 27A et 27B pour compenser les variations locales d'épaisseur résultant de la formation de l'antenne 23 et du bobinage de couplage associé 25 sur la feuille de support 26, deux couches de cœur 28A et 28B situées respectivement de part et d'autre de la feuille de support (et des éventuelles couches de compensation) et portant les motifs visuels prévus pour la carte, et deux couches de couverture 29A et 29B assurant la protection des couches sous-jacentes.

En pratique, la feuille de support 26 peut être en polyéthylène téraphtalate (PET en abrégé), mais peut aussi être réalisée en un matériau tel que du polychlorure de vinyle (ou PVC) ou du polycarbonate (ou PC en abrégé) : ce sont des matériaux généralement rigides. Les couches de compensation 27A et/ou 27B peuvent être formées dans l'un des matériaux précités, de même que les couches de cœur ; si ces couches sont formées en un même matériau, les interfaces entre ces couches peuvent être à peine détectables. Les couches de couverture, dont la fonction est principalement de protéger les couches sous-jacentes, sont souvent transparentes.

Les diverses solutions connues sont généralement complexes de mise en œuvre (nombreuses couches, ou surmoulage par injection ; contraintes dans le choix des matériaux compte tenu des opérations de dépôt-gravure classiquement utilisées ; formation de bobinage autour du microcircuit, etc.) et ne permettent pas d'avoir à la fois une faible distance entre les bobinages de couplage (donc un couplage efficace) et une bonne reproductibilité de cette configuration relative entre ces bobinages de couplage.

A ce propos, il peut être rappelé que :
- Les tolérances de positionnement de l'antenne sur la feuille de support sont typiquement de l'ordre de 0,5 mm,
- Les tolérances d'impression pour les motifs visuels sont typiquement de l'ordre de 0,1 à 0,2 mm,
- Les tolérances de superposition de l'empilement de couches sont typiquement de l'ordre de 0,2 à 0,3 mm,
- Les tolérances de lamination sont typiquement de l'ordre de 0,1 à 0,2 mm,
- Les tolérances de poinçonnage (pour délimiter le contour du corps de carte) sont typiquement de l'ordre de 0,3 à 0,5 mm
- Les tolérances de l'usinage de la cavité sont typiquement de l'ordre de 0,05 mm et
- Les tolérances de l'insertion du module dans la cavité sont typiquement de l'ordre de 0,05 mm.

Il n'y a donc rien d'excessif à conclure que les tolérances globales, en moyenne quadratique, sont de l'ordre du millimètre.

On comprend que de tels inconvénients de complexité et d'imprécision sur la distance entre des bobinages de couplage peuvent se constater indépendamment du fait que l'entité électronique ait effectivement une interface de communication à l'extérieur par contact.

L'invention vise à surmonter les inconvénients précités et propose à cet effet un entité électronique selon la revendication 1.

Dans le contexte, une faible épaisseur est une épaisseur au plus égale à 10 microns, de préférence une épaisseur au plus égale à 5 microns, voire 2 microns, voire une épaisseur au plus égale à un micron.

Il s'agit avantageusement d'une carte à microcircuit , par exemple une carte conforme aux normes en vigueur, notamment ISO 7816, par exemple une carte de format 1FF, 2FF, 3FF ou 4FF, notamment, mais il peut aussi s'agir de cartes ayant d'autres formats, choisis en fonction des besoins.

Le module peut comporter des plages de contacts destinées à pouvoir être mises en contact avec des plages de contact d'un lecteur extérieur suivant une configuration connue ; l'entité électronique est alors du type à interface duale.

De manière préférée, l'antenne et le second bobinage sont formés dans un même plan.

De manière également préférée, l'antenne et/ou le second bobinage sont formés d'une encre conductrice.

De manière avantageuse, le premier bobinage de couplage est formé d'une encre conductrice ; lorsque l'antenne et le second bobinage sont également formés d'une telle encre conductrice, il en découle une grande simplicité de fabrication.

De manière également avantageuse, l'antenne et le second bobinage de couplage sont formés à l'interface entre deux couches de cœur dont la couche située au-dessus de cette interface a une épaisseur au plus égale à la moitié de l'épaisseur de la couche située sous cette interface.

De manière également avantageuse, l'antenne et le second bobinage de couplage sont formés sur la surface supérieure de la couche de cœur la plus proche de la surface supérieure du corps, en étant masqués.

De manière avantageuse, le corps comporte une unique couche de cœur.

De manière préférée, l'antenne et le second bobinage de couplage sont recouverts d'une couche d'encre non conductrice de masquage.

De manière également préférée, l'entité comporte une couche de couverture intermédiaire entre la surface portant l'antenne et le second bobinage de couplage et la couche de couverture supérieure, des motifs décoratifs étant formés sur la couche de couverture intermédiaire.

De manière avantageuse, le premier bobinage de couplage est en regard du second bobinage de couplage dans le sens de l'épaisseur du corps.

De manière avantageuse, en variante du précédent paragraphe, le premier bobinage de couplage est en regard du second bobinage de couplage parallèlement à la surface supérieure du corps.

Et par exemple, le film de support du module porte, sur sa face externe, des plages de contact destinées à pouvoir être mises en contact avec des plages de contact d'un équipement extérieur selon une configuration connue.

L'invention propose en outre, pour la fabrication d'une entité électronique du type précité, un procédé selon la revendication 14.

Les caractéristiques avantageuses mentionnées à propos de l'entité électronique peuvent se retrouver dans le procédé ; en particulier la formation du module peut comporter la formation de plages de contact pour assurer une interface duale ; de même le corps peut être conformé en sorte que l'entité soit conforme à l'une des normes existantes.

Par exemple, la formation du second bobinage et la formation de l'antenne sont faites par dépôt d'une encre conductrice.

Des objets, caractéristiques et avantages de l'invention ressortent de la description qui suit, donnée à titre d'exemple illustratif non limitatif en regard des dessins annexés sur lesquels :
- La figure 1 est un schéma de principe d'une entité électronique ayant une interface duale,
- La figure 2 est une vue en coupe transversale d'une entité électronique selon l'art antérieur, avec 7 couches laminées,
- La figure 3 est une vue en coupe transversale d'une entité électronique selon un premier mode de réalisation de l'invention,
- La figure 4 est une vue en coupe transversale d'une autre entité électronique selon un second mode de réalisation de l'invention,
- La figure 5 est une vue en coupe transversale d'une autre entité électronique, selon une variante de ce second mode de réalisation de l'invention,
- La figure 6 est une vue en coupe transversale d'une autre entité électronique selon encore une autre variante de ce second mode de réalisation, et
- La figure 7 est une vue de dessus d'une portion du corps de la figure 3.

La figure 3 représente une entité électronique à interface duale qui est conforme à l'invention.

Cette entité, désignée sous la référence générale 30, comporte un corps 30B et un module 30A.

Le module 30A est similaire à celui de la figure 2 en ce sens qu'il comporte un film de support comportant des contacts (non représentés) sur une face externe (vers le haut sur la figure 3) et un microcircuit fixé à sa face interne (vers le bas sur cette figure), ce microcircuit 31 étant noyé dans une masse de résine de protection. En outre, un bobinage de couplage 32 est formé sur cette face interne, latéralement à distance de de la masse de résine de protection.

Le corps 30B comporte ici un nombre pair de couches, à savoir deux couches de cœur 38A et 38B et deux couches de couverture 39A et 39B.

L'antenne 33 et le second bobinage de couplage 35 sont réalisés par sérigraphie ou par impression par jet d'encre d'une encre conductrice sur l'une des faces en regard des couches de cœur ; cela a pour conséquence que cette antenne 33 et ce second bobinage a une très faible épaisseur, ce qui rend inutile de prévoir une ou plusieurs couches de compensation ; cela rend même inutile de prévoir une couche centrale de support. C'est la raison pour laquelle, à la différence de la structure de la figure 2, la figure 3 ne comporte ni feuille centrale de support ni couches de compensation.

En outre, la couche de cœur supérieure 38A a une épaisseur significativement inférieure à celle de la couche de cœur inférieure 38B, ce qui a pour effet de localiser, après lamination, l'antenne et surtout le second bobinage de couplage bien plus près du film support du module que dans la figure 2. La couche de cœur supérieure 38A a en pratique une épaisseur au plus égale à la moitié de celle de la couche de cœur inférieure 38B.

La cavité dans laquelle le module est destiné à être fixé est formée de manière classique, avec un lamage périphérique et une portion centrale de profondeur sensiblement plus importante, par exemple de l'ordre de 350 microns. Cette cavité traverse la couche de cœur supérieure, à l'intérieur des spires du second bobinage, et pénètre dans la couche de cœur inférieure, le lamage ne pénétrant que partiellement dans la couche de cœur supérieure.

Puisque le premier bobinage est formé sur la face interne du film support du module, latéralement à l'écart de la masse de résine protégeant le microcircuit, il en découle que ce premier bobinage fait face au lamage ; il se trouve donc en regard de la matière de collage qui assure en pratique la fixation du module au corps.

Puisque l'interface entre ces couches de cœur est, par rapport à la figure 2, significativement décalé vers le haut, il en découle que la distance entre les bobinages 32 et 35 peut être très faible, typiquement de l'ordre de 100 microns voire moins, cette distance étant la distance entre la profondeur du lamage et la profondeur, par rapport à la surface supérieure, de cette interface entre couches de cœur.

Ainsi, l'antenne et le second bobinage sont recouverts par la couche supérieure de cœur (en pratique opaque).

Le bobinage de couplage 35 formé dans le corps de carte a avantageusement une géométrie au moins approximativement égale à celle du bobinage de couplage 32 du module, de manière à ce que ces bobinages soient aussi exactement que possible en regard l'un de l'autre, sans décalage latéral.

On comprend aisément que la réduction du nombre de couches se traduit par une simplification sensible du procédé de fabrication d'une telle structure. En outre, cette réduction du nombre de couches permet de réduire les tolérances de fabrication, et donc une amélioration de la reproductibilité du positionnement entre les bobinages de couplage. Compte tenu de la faible distance qui peut être garantie entre les bobinages de couplage, les dimensions de ces bobinages de couplage peuvent être réduites, notamment leurs épaisseurs, ce qui conforte le choix d'une fabrication de ces bobinages par impression. En effet, le bobinage de couplage du module est avantageusement réalisé, comme le bobinage de couplage de l'antenne, par impression.

A titre d'exemple, les couches sont réalisées en PVC et ont des épaisseurs de 60 µm (pour la couche 39A), 200 µm (pour la couche 38A), 480 µm (pour la couche 38B), et 60 µm (pour la couche 39B), respectivement.

L'encre d'impression utilisée pour la formation de l'antenne et du second bobinage de couplage (voire la formation du premier bobinage de couplage) est une encre conductrice de tout type connu mais il s'agit de préférence d'une encre formée de nanoparticules, qu'on peut trouver dans le commerce sous les marques «GENES'INK®» et « NANOPCHEM® ». De telles encres présentent une résistivité très réduite par rapport aux encres classiques et peuvent être appliquées par sérigraphie ou par impression par jet ; on peut donc se contenter de former des films de 0.25 microns d'épaisseur avec une résistivité de 3 micro-ohms.cm (pour permettre une comparaison, l'argent a une résistivité de 1,6 micro-ohms.cm). On comprend qu'en conséquence, il est correct de considérer que l'épaisseur de l'antenne et du second bobinage de couplage est négligeable.

La figure 4 représente un autre exemple de réalisation d'une entité électronique conforme à l'invention.

Comme précédemment, cette entité, notée 40 dans son ensemble, comporte un module noté 40A et un corps 40B.

Le module 40A peut être identique au module 30A de la figure 3 avec un microcircuit 41 noyé dans une masse de résine fixée à la face interne d'un film de support sur lequel est formé en outre le premier bobinage de couplage 42.

Quant au corps 40B, il se distingue de celui de la figure 3 par le fait que l'antenne 43 et le second bobinage de couplage sont formés sur la face supérieure de la couche de cœur la plus proche de la surface supérieure du corps. Dans l'exemple représenté, il n'y a même qu'une seule couche de cœur 48 ; bien entendu, cette couche de cœur unique peut être remplacée par une paire de couches de cœur superposées, mais quel que soit le nombre de couche de cœur, l'antenne et le second bobinage sont formés sur la face supérieure de la couche située la plus en haut (dans l'orientation de la figure 4).

Comme précédemment, cette antenne et ce second bobinage de couplage sont réalisés par impression (par sérigraphie, par impression par jet d'encre ou toute autre technique appropriée) ; de la sorte cette antenne et ce second bobinage ne forment que des surépaisseurs tout à fait faibles. Cela permet d'appliquer une couche supplémentaire d'encre (non conductrice) au-dessus de cette antenne et de ce second bobinage en sorte de masquer cette antenne et ce second bobinage de couplage ; il suffit de choisir une encre dont la teinte est similaire à celle de la couche de cœur supérieure (éventuellement unique, voir ci-dessus), par exemple blanche. Ainsi, la présence de l'antenne et du second bobinage sur la surface supérieure de la couche de cœur ne nuit pas à l'esthétique du corps, compte tenu de ce que la couche de couverture est transparente, de manière habituelle. Il est à noter que la fluidité de la couche d'encre non conductrice fait que la couche formée sur l'antenne et le second bobinage de couplage et sur le reste de la couche de cœur constitue une sorte de couche de compensation, de faible épaisseur ; elle est notée 49C.

On peut noter que, dans cette configuration de la figure 4, le second bobinage de couplage peut être situé aussi près qu'on le souhaite du bobinage de couplage 42 porté par le module.

En effet, le lamage entourant la cavité à la figure 4 est situé à l'interface entre la couche supérieure de couverture et la couche formée par l'encre non conductrice de masquage recouvrant l'antenne et le second bobinage et le reste de la surface supérieure de la couche de coeur ; l'écart entre les deux bobinages de couplage est donc ici défini par l'épaisseur de la couche d'encre non conductrice de masquage.

On appréciera que, comme dans l'exemple précité, la minimisation du nombre de couches contribue à simplifier le procédé de fabrication et permet l'obtention, de manière très reproductible, d'un écartement très faible entre les bobinages de couplage.

A titre d'exemple, les couches sont réalisées en PVC et ont des épaisseurs de 200 µm (pour la couche 49A), 400 µm (pour la couche 48) et 200 µm (pour la couche 49B), respectivement.

L'encre non conductrice peut être de tout type connu approprié. Il s'agit par exemple d'une encre classique de type offset ou sérigraphie ; elle est appliquée ici sur une épaisseur de 3 à 5 µm (pour la couche 49C), qui lui permet d'assurer un masquage efficace ; il a été vérifié qu'elle ne réagit pas avec une encre conductrice, notamment une encre à base de nanoparticules, et reste stable vis-à-vis de celle- ci au cours du temps et conserve donc sa capacité de masquage au cours du temps.

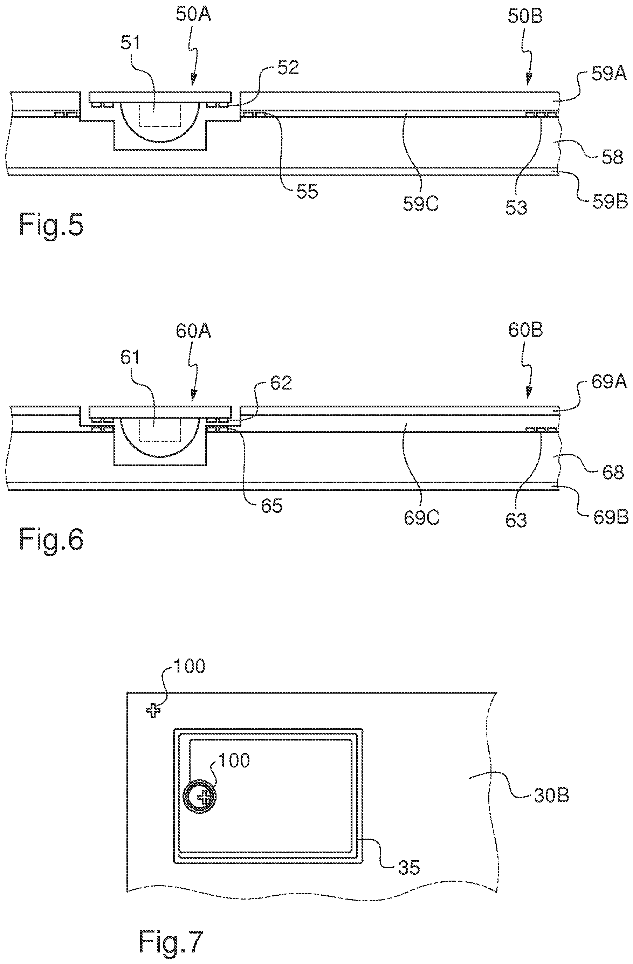

La figure 5 est une variante de la figure 4. L'entité qui y est représentée sous la référence 50 y comporte, comme dans la figure 4, un module 50A et un corps 50B, le module 50A comportant, comme le module 40A de la figure 4, un microcircuit 51 englobé dans une masse de résine fixée sur la face interne d'un film de support, autour de laquelle est formé un bobinage de couplage 52.

Le corps 50B comporte, comme le corps 40B de la figure 4, une unique couche de cœur 58, sur la surface supérieure de laquelle sont formés, par impression d'une encre conductrice, une antenne 53 et un second bobinage de couplage 55 recouverts d'une encre non conductrice de masquage 59C.

A la différence de la configuration de la figure 4, où la couche de couverture 49A est significativement plus épaisse que dans la configuration de la figure 2 ou 3, la couche de couverture 59A du corps 50B a une épaisseur similaire à celle des figures précédentes et similaire à celle des couches de couverture inférieure. Il en résulte que, compte tenu de l'épaisseur habituelle du film de support du module, le lamage se trouve au niveau, ou légèrement sous le niveau, de l'interface entre la couche de cœur et la couche de couverture supérieure ; en conséquence ce lamage se trouve au niveau (ou légèrement sous le niveau) du second bobinage de couplage 55 ; ce second bobinage doit donc, pour pouvoir être traversé par la portion centrale de la cavité ainsi que par son lamage, être de plus grande dimension que le premier bobinage 52 porté par le module. Par contre, l'écartement entre ces bobinages 52 et 55 peut n'être constitué que par cet élargissement, n'ayant aucune composante verticale (ces bobinages se trouvent sensiblement à la même profondeur vis-à-vis de la surface supérieure du corps.

A titre d'exemple, les couches sont réalisées en PVC et ont des épaisseurs de 60 µm (pour la couche 59A), 35 µm (pour la couche 59C), 680 µm (pour la couche 58A) et 60 µm (pour la couche 59B), respectivement.

La figure 6 représente encore une autre forme de réalisation d'une entité conforme à l'invention ; la principale différence réside dans la présence de deux couches de couverture.

En pratique, les motifs décoratifs du corps sont formés sur la surface située juste sous la couche supérieure de couverture ; dans les exemples des figures 3 à 5, cela signifie que ces motifs sont réalisés sur la couche d'encre de masquage (non conductrice).

L'entité électronique de la figure 6 comporte ainsi un module 60A (similaire aux modules des figures précédentes, avec un film support portant, sur sa face interne, un microcircuit 61 et, autour de la masse de résine englobant ce microcircuit, un premier bobinage de couplage 62), et un corps 60B comportant une couche de cœur 68 et, sur la surface supérieure de cette couche de cœur, une antenne 63 et un bobinage de couplage 65 réalisés par impression d'une encre conductrice.

Ce corps comporte en outre, une couche de couverture supérieure 69A et une couche de couverture inférieure 69B ; ce corps comporte ici en outre une couche de couverture intermédiaire 69C. C'est sur cette couche intermédiaire que sont formés les motifs décoratifs, et non pas à l'interface où sont formés l'antenne et le second bobinage de couplage

Cette couche de couverture peut être opaque, et masquer l'antenne et le second bobinage de couplage ; en variante et de manière préférée, elle est elle-même transparente, les motifs décoratifs masquant en eux-mêmes l'antenne et ce second bobinage.

A titre d'exemple, les couches sont réalisées en polycarbonate en ce qui concerne les couches transparentes (les couches de couverture) et en PVC, et ont des épaisseurs de 100 µm (pour la couche 69A), 100 µm (pour la couche 69C), 500 µm (pour la couche 68), et 100 µm (pour la couche 69B), respectivement.

Il va de soi que, en variante de la figure 6, le second bobinage peut, par analogie avec la figure 5, être situé au moins approximativement au même niveau (du point de vue profondeur) que le premier bobinage, en encerclant celui-ci. En fait les diverses variantes mentionnées ci-dessus à propos des diverses figures peuvent se combiner, en fonction des besoins ou des préférences du concepteur.

Il est à noter que la formation par impression de l'antenne et du second bobinage peut être accompagnée de la formation de signes de repérage. Ainsi la figure 7 représente, de manière schématique, une portion de corps de carte, ici une partie du corps de carte de la figure 3 ; on voit ainsi, par transparence au travers de la couche de couverture, non seulement le second bobinage 35 (l'antenne a été omise, par souci de simplicité du dessin) mais aussi des repères 100. On comprend aisément que ces repères 100 permettent une très grande précision au moment de creuser par usinage la cavité et son lamage, ce qui contribue à garantir une très grande reproductibilité de la configuration relative entre les deux bobinages de couplage.

On peut noter que les divers exemples décrits ci-dessus ont en commun de représenter une entité électronique (ayant ici une interface duale), par exemple du type carte à microcircuit suivant les normes en vigueur, notamment ISO 7816, comportant un module formé d'un film de support portant (en combinaison, de préférence, avec, sur une face dite face externe, des plages de contact destinées à être mises en contact avec des plages de contact d'un lecteur extérieur suivant une configuration connue), sur une face dite face interne, un microcircuit et un premier bobinage de couplage, et un corps comportant une cavité dans laquelle ce module est fixé, la surface externe longeant au moins approximativement (avec une tolérance pouvant être de l'ordre de plusieurs centaines de microns) une surface dite surface supérieure de ce corps, et contenant une antenne et un bobinage de couplage connecté à cette antenne et destiné au couplage de l'antenne avec le microcircuit par couplage électromagnétique avec le premier bobinage de couplage, ce second bobinage de couplage (voire l'antenne) étant formés, sur une épaisseur d'au plus quelques microns (ici par dépôt d'une encre conductrice), dans un plan situé, par rapport à la surface supérieure du corps, à une distance inférieure à la moitié de la distance par rapport à la surface opposée à cette surface supérieure de ce corps.

De manière avantageuse, le premier bobinage est situé dans un plan parallèle à celui de l'antenne et du second bobinage, et est formé de préférence, lui aussi, d'une encre conductrice.

Il convient de noter que, lorsque l'antenne et le second bobinage de couplage sont formés d'une encre conductrice, leurs épaisseurs sont très faibles, de l'ordre d'au plus cinq microns, ce qui constitue une surépaisseur ne nécessitant aucune compensation au sein d'une superposition de couches.

De manière générale, les divers exemples décrits ci-dessus sont fabriqués suivant les étapes suivantes :
- Formation d'un module comportant un film de support portant, sur une face dite face interne, un microcircuit et un premier bobinage de couplage
- Formation d'au moins une couche de cœur,
- Formation sur une surface de cette couche de cœur d'un second bobinage de couplage, sur une épaisseur d'au plus quelques microns (ici par dépôt d'une encre conductrice),
- Lamination d'au moins cette couche de cœur entre deux couches de couverture en sorte de former un corps ayant une surface supérieure et une surface inférieure, tel que le second bobinage de couplage se trouvent dans un plan situé à une distance de la surface supérieure qui est au plus égale à la moitié de la distance de ce plan à cette surface inférieure, ce corps comportant une antenne connectée à ce second bobinage,
- Formation dans ce corps d'une cavité,
- Et fixation de ce module dans cette cavité d'une manière telle que le second bobinage est adapté à coopérer par couplage électromagnétique avec le premier bobinage pour coupler l'antenne au microcircuit.

On comprend aisément que l'invention s'applique tout particulièrement bien à des cartes à microcircuit du type normalisé connu sous le nom ID-1, ou 1FF, mais s'applique aussi à des cartes de type ID-000 ou 2FF, voire à des formats plus petits tels que 3FF ou 4FF.

Diverses variantes de ce qui précède peuvent être envisagées, par exemple la formation de l'antenne et du second bobinage à des niveaux différents, par exemple formés sur les faces respectives d'une couche de cœur en étant reliées par des vias.

## Revendications

1. Entité électronique comportant un module (30A, 40A, 50A, 60A) formé d'un film de support portant, sur une face dite face interne, un microcircuit (31, 41, 51, 61) et un premier bobinage de couplage (32, 42, 52, 62), et un corps (30B, 40B, 50B, 60B) comportant une cavité dans laquelle ce module est fixé, le film de support ayant une surface dite surface externe longeant au moins approximativement une surface dite surface supérieure de ce corps, et contenant une antenne (33, 43, 53, 63) et un second bobinage de couplage (35, 45, 55, 65) connecté à cette antenne et destiné au couplage de l'antenne avec le microcircuit par couplage électromagnétique avec le premier bobinage de couplage, **caractérisée en ce que** ce second bobinage de couplage est formé sur une épaisseur d'au plus égale à 10 microns dans un plan situé, par rapport à la surface supérieure du corps, à une distance inférieure à la moitié de la distance par rapport à la surface opposée à cette surface supérieure de ce corps.

2. Entité selon la revendication 1 dont l'antenne et le second bobinage sont formés dans un même plan.

3. Entité selon la revendication 1 ou la revendication 2, dont l'antenne et/ou le second bobinage sont formés d'une encre conductrice.

4. Entité selon l'une quelconque des revendications 1 à 3 dont le premier bobinage de couplage est formé d'une encre conductrice.

5. Entité selon l'une quelconque des revendications 1 à 4, dans laquelle l'antenne (33) et le second bobinage de couplage (35) sont formés à l'interface entre deux couches de cœur (38A, 38B) dont la couche (38A) située au dessus de cette interface a une épaisseur au plus égale à la moitié de l'épaisseur de la couche (38B) située sous cette interface.

6. Entité selon l'une quelconque des revendications 1 à 4, dans laquelle l'antenne (43) et le second bobinage de couplage (45) sont formés sur la surface supérieure de la couche de cœur (48) la plus proche de la surface supérieure du corps, en étant masqués.

7. Entité selon la revendication 6, dont le corps comporte une unique couche de cœur (48).

8. Entité selon la revendication 6 ou la revendication 7, dans laquelle l'antenne et le second bobinage de couplage sont recouverts d'une couche d'encre non conductrice de masquage (49C).

9. Entité selon l'une quelconque des revendications 6 à 8, comportant une couche de couverture intermédiaire (69C) entre la surface portant l'antenne et le second bobinage de couplage et la couche de couverture supérieure (69A), des motifs décoratifs étant formés sur la couche de couverture intermédiaire.

10. Entité selon l'une quelconque des revendications 1 à 9, dans laquelle le premier bobinage de couplage (32, 42, 62) est en regard du second bobinage de couplage (35, 45, 65) dans le sens de l'épaisseur du corps.

11. Entité selon l'une quelconque des revendications 1 à 9, dans laquelle le premier bobinage de couplage (52) est en regard du second bobinage de couplage (55) parallèlement à la surface supérieure du corps.

12. Entité selon l'une quelconque des revendications 1 à 11, constituée d'une carte à microcircuit de type 1FF, 2FF, 3FF ou 4FF.

13. Entité selon l'une quelconque des revendications 1 à 12, dont le film de support du module porte, sur sa face externe, des plages de contact destinées à pouvoir être mises en contact avec des plages de contact d'un équipement extérieur selon une configuration connue.

14. Procédé de fabrication d'une entité électronique telle que définie dans l'une quelconque des revendications 1 à 13, comportant les étapes suivantes :
- Formation d'un module (30A, 40A, 50A, 60A) comportant un film de support portant, sur une face dite face interne, un microcircuit (31, 41, 51, 61) et un premier bobinage de couplage (32, 42, 52, 62),
- Formation d'au moins une couche de cœur,
- Formation sur une surface de cette couche de cœur d'un second bobinage de couplage (35, 45, 55, 65), sur une épaisseur d'au plus égale à 10 microns,
- Lamination d'au moins cette couche de cœur entre deux couches de couverture (39A, 39B, 49A, 49B, 59A, 59B, 69A, 69B) en sorte de former un corps ayant une surface supérieure et une surface inférieure, tel que le second bobinage de couplage se trouve dans un plan situé à une distance de la surface supérieure qui est au plus égale à la moitié de la distance de ce plan à cette surface inférieure, ce corps comportant une antenne connectée à ce second bobinage,
- Formation dans ce corps d'une cavité,
- Et fixation de ce module dans cette cavité d'une manière telle que le second bobinage est adapté à coopérer par couplage électronique avec le premier bobinage pour coupler l'antenne au microcircuit.

15. Procédé selon la revendication 14, selon lequel la formation du second bobinage et la formation de l'antenne sont faites par dépôt d'une encre conductrice.

## Patentansprüche

1. Elektronische Entität mit einem Modul (30A, 40A, 50A, 60A), das aus einer Trägerfolie gebildet ist, die an einer sogenannten Innenfläche eine Mikroschaltung (31, 41, 51, 61) und eine erste Kopplungsspule (32, 42, 52, 62) aufweist, und einem Körper (30B, 40B, 50B, 60B) mit einem Hohlraum, in dem das Modul befestigt ist, wobei die Trägerfolie eine sogenannte Außenfläche aufweist, die mindestens ungefähr entlang einer sogenannten Oberseite dieses Körpers verläuft, sowie eine Antenne (33, 43, 53, 63) und eine zweite Kopplungsspule (35, 45, 55, 65) umfasst, die mit dieser Antenne verbunden ist und zur Kopplung der Antenne an die Mikroschaltung über elektromagnetische Kopplung mit der ersten Kopplungsspule dient, **dadurch gekennzeichnet, dass** diese zweite Kopplungsspule über eine Dicke von höchstens gleich 10 Mikrometer in einer Ebene gebildet ist, die zur Oberseite des Körpers in einer Entfernung angeordnet ist, die weniger als der Hälfte der Entfernung zu einer der Oberseite dieses Körpers gegenüberliegenden Fläche entspricht.

2. Entität nach Anspruch 1, wobei die Antenne und die zweite Spule in derselben Ebene gebildet sind.

3. Entität nach Anspruch 1 oder Anspruch 2, wobei die Antenne und/oder die zweite Spule aus einer leitfähigen Tinte gebildet sind.

4. Entität nach einem beliebigen der Ansprüche 1 bis 3, wobei die erste Kopplungsspule aus einer leitfähigen Tinte gebildet ist.

5. Entität nach einem beliebigen der Ansprüche 1 bis 4, wobei die Antenne (33) und die zweite Kopplungsspule (35) an der Grenzschicht zwischen zwei Kernschichten (38A, 38B) gebildet sind, wobei die Schicht (38A) über dieser Grenzschicht eine Dicke aufweist, die höchstens der Hälfte der Dicke der Schicht (38B) unter dieser Grenzschicht entspricht.

6. Entität nach einem beliebigen der Ansprüche 1 bis 4, wobei die Antenne (43) und die zweite Kopplungsspule (45) auf der Oberseite der Kernschicht (48) gebildet sind, die sich am nächsten zur Oberseite des Körpers befindet, wobei diese maskiert sind.

7. Entität nach Anspruch 6, wobei der Körper eine einzige Kernschicht (48) aufweist.

8. Entität nach Anspruch 6 oder Anspruch 7, wobei die Antenne und die zweite Kopplungsspule mit einer Maskierungsschicht aus nicht leitfähiger Tinte (49C) beschichtet sind.

9. Entität nach einem beliebigen der Ansprüche 6 bis 8, wobei diese Entität eine mittlere Deckschicht (69C) zwischen der Fläche mit der Antenne und der zweiten Kopplungsspule und der oberen Deckschicht (69A) aufweist, wobei dekorative Motive auf der mittleren Deckschicht gebildet sind.

10. Entität nach einem beliebigen der Ansprüche 1 bis 9, wobei die erste Kopplungsspule (32, 42, 62) gegenüber der zweiten Kopplungsspule (35, 45, 65) in Richtung der Körperdicke angeordnet ist.

11. Entität nach einem beliebigen der Ansprüche 1 bis 9, wobei die erste Kopplungsspule (52) gegenüber der zweiten Kopplungsspule (55) parallel zur Oberseite des Körpers angeordnet ist.

12. Entität nach einem beliebigen der Ansprüche 1 bis 11, wobei diese Entität aus einer Mikroschaltungskarte des Typs 1FF, 2FF, 3FF oder 4FF besteht.

13. Entität nach einem beliebigen der Ansprüche 1 bis 12, wobei die Trägerfolie des Moduls an dessen Außenfläche Kontaktstellen aufweist, die dazu gedacht sind, mit den Kontaktstellen einer externen Ausrüstung nach einer bekannten Konfiguration in Kontakt gebracht zu werden.

14. Verfahren zur Herstellung einer elektronischen Entität nach einem beliebigen der vorstehenden Ansprüche 1 bis 13, wobei das Verfahren folgende Schritte umfasst:
- Bildung eines Moduls (30A, 40A, 50A, 60A) mit einer Trägerfolie, die an einer sogenannten Innenfläche eine Mikroschaltung (31, 41, 51, 61) und eine erste Kopplungsspule (32, 42, 52, 62) aufweist,
- Bildung mindestens einer Kernschicht,
- Bildung, auf einer Fläche dieser Kernschicht, einer zweiten Kopplungsspule (35, 45, 55, 65) über eine Dicke von höchstens gleich 10 Mikrometer,
- Laminierung mindestens dieser Kernschicht zwischen zwei Deckschichten (39A, 39B, 49A, 49B, 59A, 59B, 69A, 69B), um einen Körper zu bilden, der eine Ober- und Unterseite aufweist, damit sich die zweite Kopplungsspule in einer Ebene befindet, die in einer Entfernung von der Oberseite angeordnet ist, die höchstens der Hälfte der Entfernung dieser Ebene zur Unterseite entspricht, wobei dieser Körper eine Antenne aufweist, die mit dieser zweiten Spule verbunden ist,
- Bildung eines Hohlraums in diesem Körper
- und Befestigung dieses Moduls in diesem Hohlraum, sodass die zweite Spule so ausgerichtet ist, dass sie über elektromagnetische Kopplung mit der ersten Spule zusammenwirkt, um die Antenne an die Mikroschaltung zu koppeln.

15. Verfahren nach Anspruch 14, wobei die Bildung der zweiten Spule und die Bildung der Antenne durch Aufbringen einer leitfähigen Tinte erfolgen.

## Claims

1. An electronic entity including a module (30A, 40A, 50A, 60A) formed of a support film bearing, on a face called inner face, a microcircuit (31, 41, 51, 61) and a first coupling coil (32, 42, 52, 62), and a body (30B, 40B, 50B, 60B) including a cavity in which this module is fixed, the support film having a surface called outer surface along at least approximately a surface called upper surface of this body, and containing an antenna (33, 43, 53, 63) and a second coupling coil (35, 45, 55, 65) connected to this antenna and intended for the coupling of the antenna with the microcircuit by electromagnetic coupling with the first coupling coil, **characterized in that** this second coupling coil is formed over a thickness of at most equal to 10 microns in a plane located, relative to the upper surface of the body, at a distance less than half the distance relative to the surface opposite this upper surface of this body.

2. The entity according to claim 1, whose antenna and second coil are formed in the same plane.

3. The entity according to claim 1 or 2, whose antenna and/or second coil are formed of a conductive ink.

4. The entity according to any one of claims 1 to 3, whose first coupling coil is formed of a conductive ink.

5. The entity according to any one of claims 1 to 4, wherein the antenna (33) and the second coupling coil (35) are formed at the interface between two core layers (38A, 38B) whose layer (38A) located above this interface has a thickness at most equal to half the thickness of the layer (38B) located under this interface.

6. The entity according to any one of claims 1 to 4, wherein the antenna (43) and the second coupling coil (45) are formed on the upper surface of the core layer (48) closest to the upper surface of the body, being masked.

7. The entity according to claim 6, whose body includes a single core layer (48).

8. The entity according to claim 6 or claim 7, wherein the antenna and the second coupling coil are covered with a layer of non-conductive masking ink (49C).

9. The entity according to any one of claims 6 to 8, including an intermediate cover layer (69C) between the surface bearing the antenna and the second coupling coil and the upper cover layer (69A), decorative patterns being formed on the intermediate cover layer.

10. The entity according to any one of claims 1 to 9, wherein the first coupling coil (32, 42, 62) is facing the second coupling coil (35, 45, 65) in the direction of thickness of the body.

11. The entity according to any one of claims 1 to 9, wherein the first coupling coil (52) is facing the second coupling coil (55) parallel to the upper surface of the body.

12. The entity according to any one of claims 1 to 11, consisting of a 1FF, 2FF, 3FF or 4FF type microcircuit card.

13. The entity according to any one of claims 1 to 12, whose module support film bears, on its outer face, contact pads intended to be brought into contact with contact pads of external equipment according to a known configuration.

14. A method for manufacturing an electronic entity as defined in any one of claims 1 to 13, comprising the following steps:
- formation of a module (30A, 40A, 50A, 60A) comprising a support film bearing, on a face called inner face, a microcircuit (31, 41, 51, 61) and a first coupling coil (32, 42, 52, 62),
- formation of at least one core layer,
- formation on a surface of this core layer of a second coupling coil (35, 45, 55, 65), over a thickness of at most equal to 10 microns,
- lamination of at least this core layer between two cover layers (39A, 39B, 49A, 49B, 59A, 59B, 69A, 69B) so as to form a body having an upper surface and a lower surface, such that the second coupling coil lies in a plane located at a distance from the upper surface which is at most equal to half the distance from this plane to this lower surface, this body comprising an antenna connected to this second coil,
- formation in this body of a cavity,
- and fixing of this module in this cavity in such a way that the second coil is adapted to cooperate by electronic coupling with the first coil to couple the antenna to the microcircuit.

15. The method according to claim 14, according to which the formation of the second coil and the formation of the antenna are made by deposition of a conductive ink.
